# EUROPEAN PATENT SPECIFICATION

(11) **EP 1 586 910 B1**
(45) Date of publication and mention of the grant of the patent: **07.01.2009**
(21) Application number: 04076104.1
(22) Date of filing: 18.04.2004
(51) Int. Cl.: G01R 31/02, G01R 27/18

(54) **Method of and device for insulation monitoring**
Verfahren und Einrichtung zur Isolationsüberwachung
Méthode et dispositif pour la surveillance de l'isolation

(43) Date of publication of application: 19.10.2005
(73) Proprietor: Deif A/S, 7800 Skive (DK)
(72) Inventor: Johannesen, Finn, 7800 Skive (DK); Hedegaard, Flemming, 7800 Skive (DK)
(74) Representative: Olesen, Kaj

(56) References cited:
- EP-A- 0 654 673

## Description

### Field of the invention

The invention relates to a method of insulation monitoring of an ungrounded electric network, for example a DC and/or an AC network, wherein an insulation impedance comprising an unavoidable ohmic and capacitive insulation resistance between network and ground exists, whereby a measuring voltage in the form of a pulsed voltage is applied to the network to be monitored between network and ground. The invention also relates to a device for performing in accordance with such a method. Further, the invention relates to uses of such a device.

### Background of the invention

In the prior art the monitoring of the insulation resistance in ungrounded AC networks has been performed by introducing a DC reference voltage and then measuring the resulting current flowing through a known resistor. Such prior art arrangements are disclosed e.g. in "Protective Measures with Insulation Monitoring", Wolfgang Hofheinz, VDE Verlag, Berlin, 2. edition, 2000.

However, such methods are not suitable when a DC voltage is comprised in the network as well.

EP 0 654 673 B 1 discloses a method of insulation monitoring of ungrounded electric DC and AC networks. According to this prior art a measuring voltage is applied in the form of a pulsed alternating voltage with different pulsed voltage values to the network, e.g. between a phase connection and earth (the hull of the ship). When a pulse has been applied, the transient state is monitored until an essentially stationary value is reached and measured. Immediately thereafter the measuring voltage is switched to the next voltage value and the monitoring/measuring step is repeated for this pulse. The two measured values are used for determining the insulation resistance. Since the difference between the values for the two pulses are used, the influence of a DC voltage, e.g. a DC generator located in the circuit, is neutralized.

A further example of such prior art is disclosed in DE 101 06 200 C1.

However, these prior art methods require that at least two different measuring pulses need to be applied before an evaluation of the insulation resistance can be performed. Since a pulse must be maintained until the transient stage is ended, and since for the resistances and capacitances involved such transient stages may be relatively long-termed, an evaluation may take considerable time according to these prior art systems.

Further, these prior art methods also require that a resistive network coupling is applied between the network to be monitored and ground in order to cope with the possible considerable DC voltage levels that may be involved in the network.

It is an objective of the invention to provide a method of and an apparatus for insulation monitoring of ungrounded electric DC and/or AC networks wherein an unavoidable ohmic and capacitive insulation resistance between network and ground exists, that provides an improvement in relation to the above-mentioned prior art.

It is further an objective of the invention to provide such a method and such an apparatus whereby an evaluation of the insulation resistance may be provided in shorter time as compared with the prior art.

It is still further an objective of the invention to provide such a method and such an apparatus whereby an evaluation of the insulation impedance, e.g. also comprising an evaluation of the capacitive leakage to ground may be performed.

Also, it is an objective of the invention to provide such a method and such an apparatus whereby an added flexibility and versatility may be achieved.

These and other objectives are achieved by the invention as explained in detail the following.

### Summary of the invention

The invention relates to a method of insulation monitoring of an ungrounded electric network, for example a DC and/or an AC network, wherein an insulation impedance comprising an unavoidable ohmic and capacitive insulation resistance between network and ground exists, whereby a measuring voltage in the form of a pulsed voltage is applied to the network to be monitored between network and ground, whereby
- initially an offset DC voltage is applied and adjusted until a possible DC voltage inherent in the network to be monitored is essentially compensated for, that
- a voltage pulse of said measuring voltage is applied to the network between network and ground, that
- a resulting current or a variable derived therefrom is monitored until a predetermined stage is reached, and that
- the resulting current or a variable derived therefrom determined at said predetermined stage is used for establishing an evaluation of the insulation impedance of the network.
   Hereby it is achieved that an evaluation of the insulation impedance, e.g. the ohmic insulation resistance, can be provided after having applied only one pulse of the measuring voltage, e.g. superimposing only one voltage pulse on the network. Thus, a result can be provided, e.g. displayed without any considerable time delay which is of importance in case a fault and in particular a potential damaging fault has developed. The importance hereof is also accentuated by the fact that due to the large capacitances normally involved in such systems, the time taken for ending a transient state after a measuring voltage pulse has been applied is considerable. Thus, the effect of having to apply only one voltage pulse before a result is achieved is very significant.
   It will be understood that the step of applying and adjusting the offset DC voltage may naturally be performed by starting with a zero voltage and checking the effect hereof, after which the offset voltage may be adjusted. This also has the advantage that if the network to be monitored does not comprise any DC sources, this step will be immediately completed since no adjustment has to take place. Thus, this step will in such a situation in practice only comprise a check of the situation.
   Advantageously, as specified in claim 2, said voltage pulse of said measuring voltage that may be positive or negative, may be terminated when said predetermined stage is reached.
   Hereby it is achieved that the length of the measuring voltage pulse may be reduced to what is necessary in the specific circumstances, i.e. the length of the applied pulses need not be fixed to a specific length that in practice in many situations will be unnecessary in order to end a transient state. Thus, hereby an enhanced efficiency and flexibility is achieved.
   In accordance with a further advantageous embodiment as specified in claim 3, said voltage pulse of said measuring voltage may be followed by a subsequent voltage pulse having a different or the same polarity,
- whereby a resulting current or a variable derived therefrom caused by said subsequent voltage pulse may be monitored until a predetermined stage is reached, and
- that the resulting current or a variable derived therefrom determined at said predetermined stage may be used for establishing a subsequent evaluation of the insulation impedance of the network.

Hereby it is achieved that results are readily provided and an in essence continuous or near-continuous monitoring of the network is achieved.

According to a preferable embodiment, as specified in claim 4, a result of said evaluation or evaluations of the insulation impedance of the network may be displayed, e.g. immediately following an evaluation and/or at least during a read-out period following a corresponding voltage pulse of said measuring voltage.

According to a further preferable embodiment, as specified in claim 5, said method may involve the application of at least two measuring voltage pulses having different polarities and whereby an evaluated insulation impedance may be provided for e.g. read-out and/or display corresponding to a positive and a negative measuring voltage pulse, respectively.

Hereby it is achieved that specific results may be provided corresponding to e.g. positive and negative measuring voltages, whereby further useful information regarding the insulation state of the network can be provided.

According to a further advantageous embodiment, as specified in claim 6, said predetermined stage may be reached when a predefined value of said resulting current or a variable derived therefrom is reached.

Hereby an added flexibility is achieved since criteria for ending each measuring pulse may be established in view of particular needs and/or circumstances, e.g. also in consideration of customer demands and specifications.

Advantageously, as specified in claim 7, said predetermined stage may be reached when an essentially stationary value of said resulting current or a variable derived therefrom is reached.

Hereby the measuring pulses may be terminated as soon as the transient state is deemed to be completed, e.g. also in consideration of certain needs, expectations, user demands etc. Thus, it may for example be determined that the transient stage is ended when the difference between to successive samples or the like is less than a predefined value, e.g. 1%, 2%, 5% etc. or an absolute value for the difference may be used. Further, the time derivative of the measured signal may be used for determining the desired stage in similar fashion.

According to a still further advantageous embodiment, as specified in claim 8, said adjustment of the DC offset voltage may be performed while monitoring a current or a derivable therefrom in said network and a possible DC voltage inherent in the network to be monitored may be considered compensated for when said DC offset voltage provides an effect essentially corresponding to said current or a derivable therefrom, for example when the difference between these is within a predefined interval, e.g. essentially zero.

It will be understood that the offset DC voltage may be applied in a number of ways and that the comparison with the effect of the DC source of the network may be performed in various manners. For example, a current stemming from the DC source of the network may be compared with a current stemming from the offset voltage, all in the context of the measuring arrangement. Also it will be understood that an offset DC voltage may be applied in the form of a current that establishes a corresponding effect for compensating the measured signal stemming from the DC source of the network.

Preferably, as specified in claim 9, it may be controlled subsequent to a termination of a voltage pulse of said measuring voltage whether said possible DC voltage inherent in the network to be monitored is compensated for by said offset DC voltage, and if necessary an adjustment may be performed.

Hereby it is achieved that the offset DC voltage level is regularly controlled and adjusted if necessary, and such a control may be configured in a numerous manners. For example, a check of the offset DC voltage level may be performed after each measuring voltage pulse, after a number of such pulses, after a predefined time interval etc., all in dependence on the nature of the network to be monitored and/or in dependence of user needs etc.

According to a further preferable embodiment, as specified in claim 10, said evaluation of the insulation impedance of the network may provide a determination of the ohmic insulation resistance of the network.

Additionally or instead, as specified in claim 11, said evaluation of the insulation impedance of the network may provide a determination of the capacitive insulation resistance of the network.

Hereby additional advantages may be achieved in cases where it is desirable or necessary to monitor the capacitive insulation resistance of the network, which may be performed in a number of ways which will be evident to a skilled person. For example, the monitored or measured signals during the transient stage may be analyzed and evaluated whereby the capacitance involved in the charging of the impedance between network and ground may be determined.

As specified in claim 12, said ungrounded electric network to be monitored may comprise loads such as rectifiers and/or other converters.

It will be understood that the method according to the invention can be utilized in connection with any type of loads and in connection with any type of network. However, networks comprising loads such as for example rectifiers and/or other converters are of particular interest.

Further, as specified in claim 13, said ungrounded electric network to be monitored may comprise one or more phases, e.g. a three-phase-network.

As explained in the following, a network can be monitored according to the invention by monitoring/measuring between a single phase line and ground, even though the network comprises more than one phase line. Thus, an impedance fault developed in connection with one phase line only can also be detected according to the invention even though measurements are performed between another phase line and ground/earth, e.g. due to connection between phase lines at the source, e.g. the generator. Thus, with a method according to the invention the insulation resistance to ground/earth will be monitored not only for the phase line for which measurements are performed, but also for the other phase lines comprised in the network system.

According to a further preferable embodiment, as specified in claim 14, said method may involve the step of activating an alarm, e.g. an audible and/or a visible alarm in case the insulation impedance is below a predefined threshold.

According to another preferable embodiment, as specified in claim 15, said method may involve the step of performing an evaluation on the basis of at least two determined insulation impedance values in order to detect and possibly indicate particular fault situations, e.g. faults relating to positive or negative branches in e.g. a converter or rectifier circuit.

Hereby a number of additional features and advantages may be achieved, including the advantage that the user may readily be informed of certain particular fault situations, e.g. involving faults specific to e.g. converter or rectifier circuits, batteries etc.

Further, the invention relates to a device for insulation monitoring of an ungrounded electric network, for example a DC and/or an AC network, wherein an insulation impedance comprising an unavoidable ohmic and capacitive insulation resistance between network and ground exists, said device comprising means for applying a measuring voltage in the form of a pulsed voltage to the network to be monitored between network and ground and means for monitoring a resulting current or a variable derived therefrom, wherein said device comprises means for applying an adjustable offset DC voltage, wherein said device further comprises means for monitoring an effect of said offset DC voltage and means for automatically adjusting the adjustable offset DC voltage until a possible DC voltage inherent in the network is compensated for.

Hereby it is achieved that an evaluation of the insulation impedance, e.g. the ohmic insulation resistance, can be provided with the device after having applied only one pulse of the measuring voltage. Thus, a result can be provided, e.g. displayed without any considerable time delay which is of importance in case a fault and in particular a potential damaging fault has developed. The importance hereof is also accentuated by the fact that due to the large capacitances normally involved in such systems, the time taken for ending a transient state after a measuring voltage pulse has been applied is considerable. Thus, the effect of having to apply only one voltage pulse before a result is achieved is very significant, and the device according to the invention is thus able to provide quick and reliable information regarding the state of the insulation impedance.

It will be understood that the means for applying and adjusting the offset DC voltage may naturally be designed in such a manner that a zero voltage is initially applied and the effect hereof is checked, after which the offset voltage may be adjusted. This also has the advantage that if the network to be monitored does not comprise any DC sources, this step will be immediately completed since no adjustment has to take place. Thus, this step will in such a situation in practice only comprise a check of the situation.

Preferably, as specified in claim 17, said device may comprise control means for performing said automatic adjustment of the adjustable offset DC voltage at specific stages, e.g. subsequent to a measuring voltage pulse and with predestined intervals, e.g. after a number of measuring voltage pulses have been applied.

Hereby it is achieved that the offset DC voltage level is regularly controlled and adjusted if necessary, and such a control may be configured in a numerous manners. For example, a check of the offset DC voltage level may be performed after each measuring voltage pulse, after a number of such pulses, after a predefined time interval etc., all in dependence on the nature of the network to be monitored and/or in dependence of user needs etc. Thus, in this manner the device may automatically, flexibly and reliably perform the monitoring of the insulation impedance.

According to a further preferable embodiment, as specified in claim 18, said device may comprise means for determining when said resulting current or a variable derived therefrom has reached a predetermined stage, e.g. a predefined value and/or an essentially stationary value of said resulting current or a variable derived therefrom, and means for terminating said measuring pulse voltage in consequence hereof.

Hereby an added flexibility is achieved since criteria for ending the measuring pulses may be established in view of particular needs and/or circumstances, e.g. also in consideration of customer demands and specifications. For example the measuring pulses may be terminated by the device as soon as the transient state is deemed to be completed, e.g. also in consideration of certain needs, expectations, user demands etc. Thus, it may for example be determined by the device that the transient stage is ended when the difference between to successive samples or the like is less than a predefined value, e.g. 1%, 2%, 5% etc. or an absolute value for the difference may be used. Further, the time derivative of the measured signal may be used for determining the desired stage in similar fashion.

Advantageously, as specified in claim 19, said device may comprise means for applying positive and/or negative measuring pulses to said network.

Hereby it is achieved that specific results may be provided by the device corresponding to positive as well as negative measuring voltages, e.g. separately for each, whereby further useful information regarding the insulation state of the network can be provided.

According to a particular preferable embodiment, as specified in claim 20, said device may comprise means for establishing an evaluation of the insulation impedance of the network on the basis of said monitored resulting current or a variable derived therefrom stemming from one or more measuring voltage pulses.

Hereby it is achieved that a number of additional features may be provided by the device, e.g. information relating to the monitored impedance, which may differ in dependence on the polarity of the measuring voltages and whereby specific fault situations may be indicated to the user. Further, the development in the impedance level may also be provided to the user.

Advantageously, as specified in claim 21, said device may comprise display means for indicating values of said insulation impedance, e.g. the ohmic and/or capacitive insulation resistance.

In a further advantageous form, as specified in claim 22, said device may comprise display means for indicating values relating to different measuring voltage pulses, e.g. negative and positive voltage pulses.

Also, as specified in claim 23, said device may comprise means such as visible and/or audible alarm means for indicating particular fault situations, e.g. when the insulation impedance is below a predefined threshold and/or faults relating to e.g. positive or negative branches in e.g. a converter or rectifier circuit..

According to a still further preferable embodiment, as specified in claim 24, said device may be designed to operate according to a method as characterized in one or more of claims 1 to 15.

Further, the invention also relates to use of a device according to one or more of claims 16 to 24 in ungrounded electric networks, for example DC and/or an AC networks, said networks comprising various load, including for example rectifiers and/or other converters.

It will be understood that the method and the device according to the invention can be utilized in connection with any type of loads and in connection with any type of network. However, networks comprising loads such as for example rectifiers and/or other converters are of particular interest.

The invention also relates to use of a device according to one or more of claims 16 to 24 in ungrounded electric networks, for example DC and/or an AC networks, said networks comprising one or more phase lines, e.g. one-phase systems, three-phase systems etc.

As explained above and in the following, a network can be monitored by a single device according to the invention, even though the network comprises more than one phase line. For example, an impedance fault developed in connection with one phase line can be detected by a device connected between another phase line and ground/earth, e.g. due to the connection between phase lines at the source, e.g. the generator. Thus, a device according to the invention will monitor the insulation resistance to ground/earth not only for the phase line to which it is connected, but also the other phase lines comprised in the network system.

Finally, the invention also relates to use of a device according to one or more of claims 16 to 24 in ungrounded electric networks in ships, transport means such as trains, rail vehicles etc, buildings, hospitals, industrial installations, mining installations, building sites etc.

### The figures

The invention will be described in further detail below with reference to the drawings of which
- fig. 1: shows an example of an ungrounded electric network with an insulation monitoring device in general,
- fig. 2: shows an example of a prior art insulation monitor in block diagram form,
- fig. 3: is a block diagram illustrating in general the principle of an apparatus and a method in accordance with an embodiment of the invention,
- fig. 4: shows in similar form an apparatus in accordance with a further embodiment of the invention, and
- figs. 5 to 8: illustrate the operation of an apparatus in accordance with the invention in the form of various measuring sequences.

### Detailed description

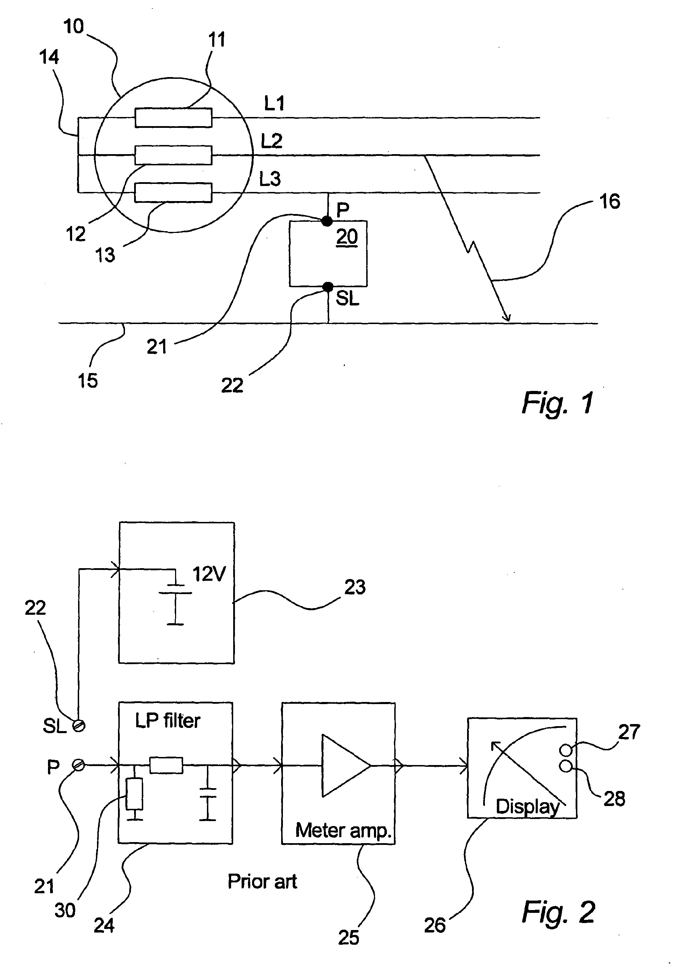

An ungrounded electric network is shown in general in fig. 1 wherein an electric generator 10 is illustrated, e.g. an AC generator with three stator windings 11, 12 and 13 that is connected to the three power lines L1, L2 and L3, respectively, and connected in a common star point 14. This star point 14 is not connected to the ground 15, e.g. the hull of a ship, the chassis of a train locomotive etc. In order to monitor the insulation resistance to ground, a monitoring device 20 is connected between one of the phase lines L1, L2 or L3 and the ground, e.g. with a phase terminal 21 connected to L1 and a ground terminal 22 connected to ground 15. Hereby, as it will be explained in further detail in the following, it is possible to monitor the insulation resistance between any of the phase lines and ground and detect whether a leakage path has been established, e.g. 16 between L2 and ground 15, and/or whether an unacceptable low insulation resistance is present.

A prior art insulation resistance monitoring device or insulation resistance meter is illustrated in fig. 2. Here, a DC source 23, e.g. a 12V battery, is shown connected to the SL terminal 22 for providing a measuring voltage. This measuring voltage is applied between ground 15 and a phase line and will cause a corresponding leakage current to flow in the circuit. This leakage current is measured with measuring means shown connected to the phase terminal 21, said measuring means comprising a lowpass filter 24 for preventing the mains frequency from disturbing the measurement. This lowpass filter 24 is also shown comprising a resistor 30 which serves as the known resistor, e.g. a resistor with small tolerances, that provides the appropriate signal to be measured, e.g. the voltage caused by the superimposed pulse voltage. Further, the signal is amplified at 25 and led to a display 26 comprising e.g. a moving-coil instrument and indicators 27 and 28, e.g. LED indicators. The pointer of the instrument 26 will show the insulation resistance on a scale, e.g. in MΩ and/or as "acceptable/not acceptable". The indicators 27 and 28 may for example indicate that the instrument is ready/on and that a fault has occurred, i.e. that the insulation resistance is below a predefined level.

Thus, the ohmic resistance between two conductors are measured by introducing a DC reference voltage and then measuring the resulting current flowing through a known resistor, e.g. the resistor 30, while the interfering AC voltage is compensated by e.g. a choke, a filter or the like. However, while this principle works very well as long as there are no voltages or AC voltages between the conductors, any DC voltages in the network render this method unsuitable. Such a DC voltage will introduce an error that is direct proportional to the reference voltage used. Further, such DC voltages of for example up to 1000V will destroy most standard ohm-meters.

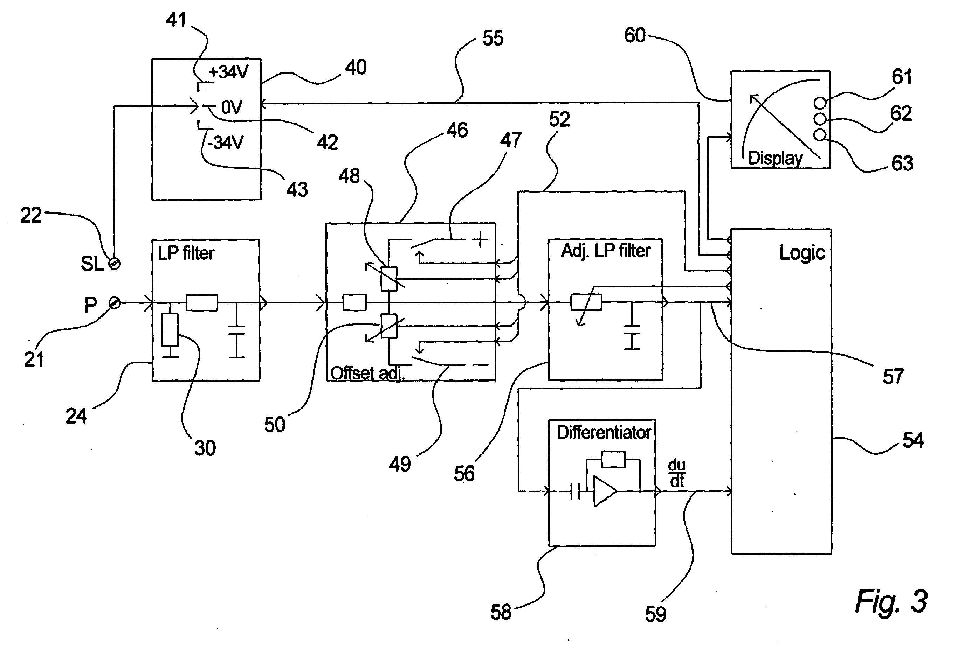

Fig. 3 is a block diagram illustrating in general the principle of an apparatus and a method in accordance with an embodiment of the invention that allows monitoring of the insulation impedance, e.g. resistance generally, e.g. also in networks comprising DC sources as well as AC sources.

Here, the measuring voltage is represented by a source 40, which involves a DC voltage that may be a battery or another form of stable electric energy source. This source 40 may as indicated be able to deliver a zero voltage, a positive voltage and/or a negative voltage as indicated by the terminals 42, 41 and 43, respectively. These terminals may be connected to the ground terminal 22 (SL) as illustrated in order to provide a measuring voltage or a zero voltage.

The measuring means are in analogy with what was explained above in connection with the prior art (fig. 2) connected to the phase terminal 21 (P), although it will be understood that the connections may be exchanged. As explained above, a lowpass filter 24 is comprised in the measuring branch for compensating the AC source, i.e. the influence of the AC frequency. This lowpass filter 24 is also shown comprising the known resistor 30 as described above. From the lowpass filter 24 the measuring signal is led to an offset adjustment generally designated 46. For illustrative purposes this is shown equipped with a positive voltage source 47, a negative voltage source 49 and adjustable resistors 48 and 50 for setting an appropriate DC offset voltage. As indicated the offset adjustment arrangement 46 may be controlled by control means in the form of a logic controller, a micro-processor or similar means 54.

After the measuring signal has passed the offset adjustment arrangement 46, a further lowpass filter 56, which is adjustable, is arranged before the measuring signal reaches the control means 54 in the form of the resulting measuring signal 57. This resulting measuring signal 57 also forms input to a differentiator 58, e.g. a means for establishing the time derivative 59 of the signal 57, which is evaluated by the control means 54. Further, the control means 54 is connected to display means 60 that may be in the form of e.g. a moving-coil instrument as described above in connection with the prior art. This display means may also comprise other indicators 61, 62 and 63, e.g. LED indicators, the function of which will be explained in further detail below.

The apparatus shown in fig. 3 may be connected to a network comprising AC as well as DC sources by means of the terminals 21 and 22. Initially, a measuring voltage will not be connected to the network, e.g. the zero voltage terminal 42 of the measuring voltage source 40 will be applied. The measuring signal from the terminal 21 will be led via the lowpass filter 24, which as already described above has the effect of removing the AC component stemming from the AC-source(s) in the network, via the offset adjustment means 46 wherein none of the voltage sources are applied, and via the adjustable lowpass filter 56 to the control means as the resulting measuring signal 57. Due to the capacitance between the phase line and the ground of the system, the measuring signal 57 will vary transiently until the capacitance has been fully charged, which state may be determined by observing the time-dependent of the signal 57, e.g. by means of the differentiator 58. When the output 59 of this has reached a stable level, e.g. essentially zero, when the level is essentially constant or does not change more than a predetermined amount for each interval, the level of the signal 57 is determined. If this is not zero (or substantially zero), a DC source is present in the network, and the insulation resistance cannot be determined by simply applying a measuring DC voltage 40. Depending on the polarity/sign of the signal 57, the control means 54 applies via the control or communication line 52 a positive 47 or a negative 49 offset voltage to the network and adjusts the offset voltage (illustrated by means of the adjustable resistors 48 or 50) until the level of the measuring signal 57 is zero (or essentially zero).

When this has been established, a measuring voltage pulse is applied, either a positive 41 or a negative 43 voltage, controlled but the control means 54 via the control or communication line 55. When a measuring pulse voltage is applied, the measuring signal 57 is observed, e.g. by forming a time derivative 59 or the like, and when it is determined that the level of the measuring signal 57 is constant (or essentially constant), this is considered to be the relevant signal for determining the insulation resistance of the network system, e.g. by methods generally known and described in the prior art. When the desired measuring signal has been determined, the measuring pulse voltage may be disconnected and the insulation resistance can be indicated on the display 60.

The function of the adjustable lowpass filter 56 will now be explained in further detail. This filter 56 serves to compensate for possible fluctuations in the measurements, e.g. caused by noise signals etc. The filter performs an averaging of variations in the measuring signal, e.g. the measured DC voltage, the measured insulation resistance, the measured current etc. The adjustable filter 56 may be controlled by the control means 54 and in such a manner that a setting of the filter giving a fast response time for the monitoring is initially used. If this setting does not give a desired result, the filter can be adjusted in order to achieve a suitable averaging of the signal, e.g. thereby also increasing the response time. For example, the filter may be adjusted incrementally or in steps, for example in five steps, wherein the last of these may provide an averaging of a frequency of e.g. 0.05 Hz.

As indicated in fig. 3, the display may comprise a number of indicators 61, 62 and 63 in addition to the pointer of e.g. a moving-coil instrument. It will be understood that instead of such a moving-coil instrument other means of indicating the value of the insulation resistance may be utilized, e.g. digital read-out means etc. One of the indicators 61 may serve to indicate that the apparatus is operational while the other two may each serve to indicate a particular type of insulation resistance fault, e.g. the polarity. For example, a fault relating to one particular branch of a rectifier of converter circuit may be indicated by the indicator 62, while a fault relating to the opposite branch may be indicated by the indicator 63. Similar regards insulation defects relating to batteries inherent in the network etc. These faults, e.g. the polarity of the defects, are detected by using different polarities for measuring pulse voltages, since a positive measuring voltage may not lead to a measured defect while a negative measuring voltage will lead to an indicated defect and vice versa for such defects in the insulation resistance. Thus, by using measuring pulse voltages of different polarities and evaluating the resulting measurements in context such further information may be provided and indicated relating to such particular fault situations. Further, it is noted that different values may simultaneously be displayed by the display means 60, e.g. the insulation resistance corresponding to negative measuring pulses and positive pulses, the insulation resistance and the insulation capacitance etc,

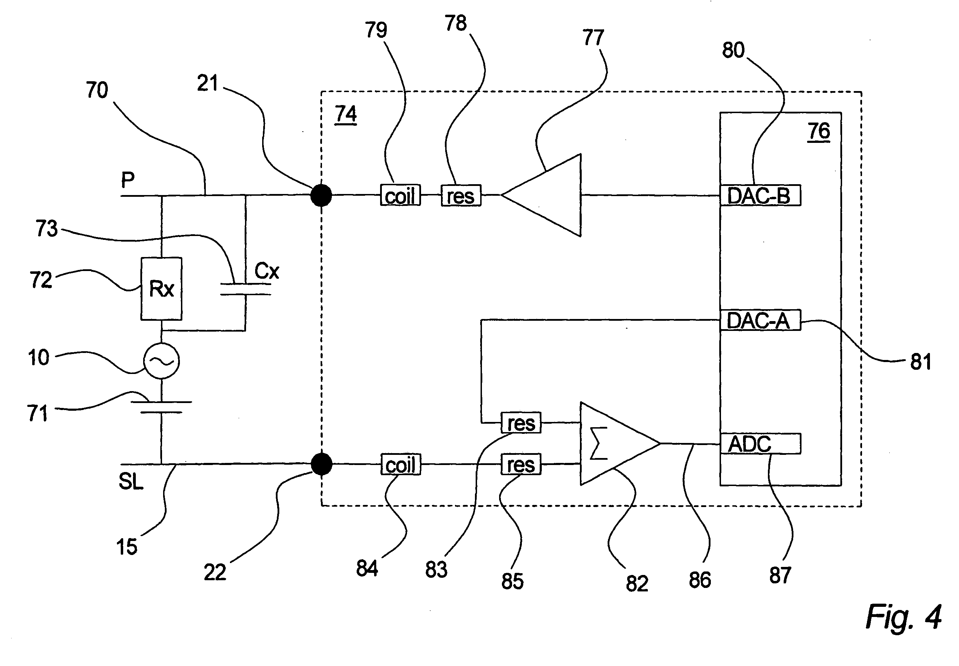

Fig. 4 shows an apparatus in accordance with a further embodiment of the invention, which, however, operates in a manner similar to the apparatus described above in connection with fig. 3. In fig. 4, the apparatus or instrument is generally designated 74 and is connected to a phase line 70 and a protection or ground line 15 (or the hull of a ship etc.). Between these two lines the insulation resistance 72, the (equivalent) capacitance 73 to the e.g. hull, an AC generator 10 and a DC generator 71 are shown. The objective of the invention is, as previously explained, to measure, monitor or evaluate the insulation resistance 72. The instrument 74 may be encapsulated in a common housing wherein also display means, e.g. a moving-coil instrument, digital means etc. (not shown in fig. 4) are located, thereby providing a compact configuration.

It will be understood that the apparatus shown in fig. 4 operates in a digitalized manner and by means of a microprocessor or the like 76, thereby also avoiding the need for analogue filters etc., since all the functions performed by the corresponding means shown in fig, 3 may be performed by e.g. the microprocessor.

As described above a zero reference voltage is applied at an initial or first stage to the conductors 15 and 70 via a digital-analogue converter (DAC-B) 80 in the microprocessor 76 via amplifier means 77, a resistor 78 and a possibly a coil 79.

By means of a differential amplifier 82 a measurement is performed, e.g. via the terminal 22, a coil 84 and a resistor 85, and the output 86 of the amplifier 82 is provided via the analogue-digital converter (ADC) 87. If this is not zero (or substantially zero) as explained above, the microprocessor 76 will provide an offset adjustment by means of the digital-analogue converter (DAC-A) 81 and a resistor 83 to the other input gate of the differential amplifier 82. The microprocessor 76 is controlled to perform an automatic offset adjustment until the output 86 of the differential amplifier 82 is zero, e.g. the output of ADC 87.

After this, the effect of the DC voltage source 71 is essentially removed and in principle an ohm measurement can take place. Thus, at this stage a reference measuring voltage is applied, e.g. by means of the digital-analogue converter (DAC-B) 80 in the microprocessor 76 via amplifier means 77, a resistor 78 and a coil 79 (optional) to the terminal 21 and the resulting current is measured (corresponding to the output from ADC 87), when the output of differential amplifier 82 or ADC 87 has reached a constant level.

The measurement and the determination of the appropriate moment in time for performing the measurement may be performed as explained above in connection with fig. 3, e.g. by evaluating the time-derivative of the signal and determining when this is substantially zero, by evaluating the measured values in consecutive intervals or the like. In practice, the appropriate time for determining the sought measurement may be determined as the moment when the difference between consecutive samples is below a predefined value.

Thus, the measured value, e.g. the output of the ADC 87, when the transient state has passed, is used for determining the insulation resistance 72, e.g. by well-known means, and displaying this on the display (not shown in fig. 4). Further, an alarm may be given is the determined value exceeds a predefined range, for example by optical, e.g. LED indicators, by an audible alarm etc.

Further, as explained above in connection with fig. 3, after a measurement has been performed, a renewed measurement may be performed by applying a new measuring pulse voltage with the same or the opposite polarity or the offset adjustment may be rechecked and adjusted, if necessary, as explained in connection with the initial stage.

Further, it is noted that by means of the device shown in fig. 3 as well as the embodiment shown in fig. 4 it is possible to monitor the capacitive insulation resistance of the network as. This may be performed in a number of ways which will be evident to a skilled person. For example, the monitored or measured signals during the transient stage may be analyzed and evaluated whereby the capacitance involved in the charging of the impedance between network and ground may be determined by e.g. a microprocessor or the like, e.g. the control means 54 or the microprocessor 76.

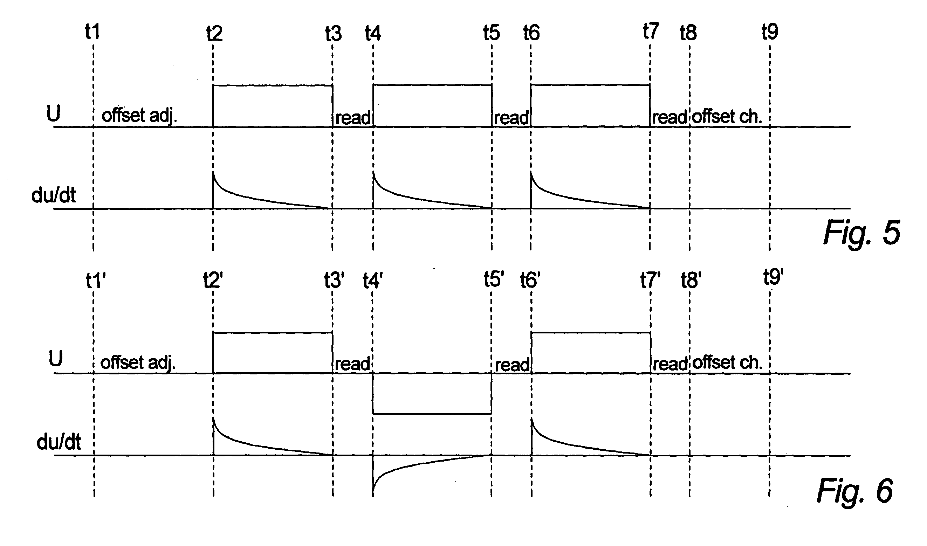

In order to further illustrate the options available with the invention and the flexibility achieved, a number of measuring sequences will be described with reference to figs. 5 to 8 that illustrate the operation of an apparatus in accordance with an embodiment of the invention. Each of these figures show a reference or a measuring voltage U that is applied to the network in question, and below this a signal is shown indicating the transient state during the application of a measuring pulse voltage, e.g. the time derivative du/dt of the measured voltage, e.g. the voltage over a known resistor, the difference between consecutive samples etc. For the sake of simplicity this signal is denoted du/dt in figs. 5 to 8, but it will be understood that any appropriate signal or value indicating e.g. the transient condition may be utilized.

In fig. 5 is shown an example where initially from t1 to t2 an offset adjustment is performed as explained above, after which a positive measuring or reference voltage pulse is applied. The transient state is monitored and at t3 it is determined that a constant level has been reached. Thus, the measuring voltage is removed and a read-out of the insulation resistance is performed. At the time t4 a new measuring pulse voltage is applied, the transient state is monitored, e.g. du/dt, when the constant level is reached at t5, a read-out of the newly determined value of the insulation resistance is performed, etc. After a predetermined number of measuring sequences, after a predetermined time interval or in dependence on other factors an offset check is performed e.g. as shown at t8 and a possible adjustment may take place until the time t9, after which a measuring voltage pulse is applied again etc.

It will be understood that an initial offset adjustment may take more time than an offset check since an initial offset adjustment may involve measures for assuring a correct setting whereas a offset check may only rarely involve a change in the setting, e.g. if the level of the DC voltage source(s) in the network has/have not changed, there is no need for a readjustment.

Further, it will be understood that even though the time intervals where a measuring pulse voltage is applied, e.g. t2 to t3, t4 to t5 and t6 to t7 are shown as being essentially of equal length in fig. 5 (and correspondingly for the following figures), it will be understood that the lengths depend on the characteristics of the network, e.g. the time taken to charge the capacitance between the network and the ground to the applied voltage, and that a measuring pulse is only applied until it is determined that the transient stage is concluded.

The example shown in fig. 6 corresponds to fig. 5 with the exception that the polarity of the measuring voltages alternates, e.g. from the time t4' to t5' a negative voltage is applied etc., whereby the above mentioned added features relating to the polarity depending fault situations are achieved.

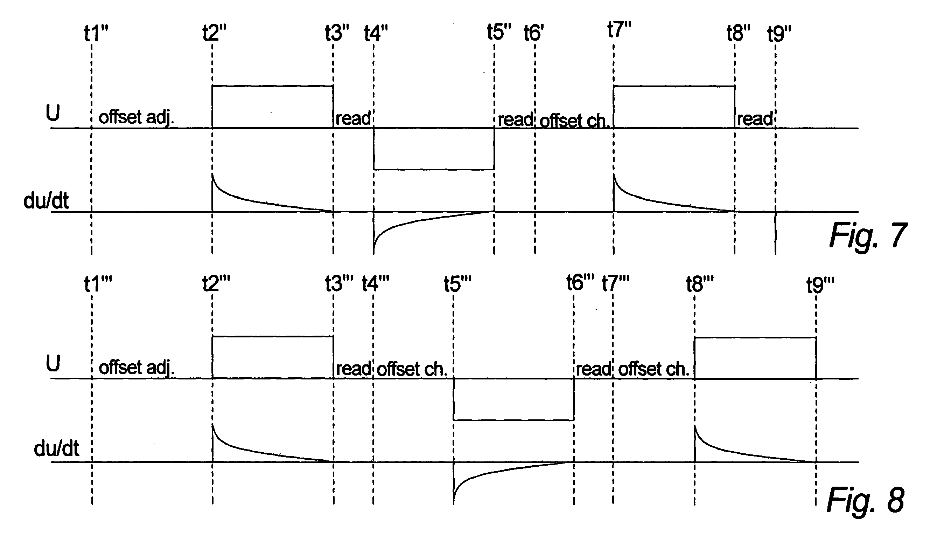

The example illustrated in fig. 7 differs from the one shown in fig. 6 in that an offset check is performed after a positive and a negative reference or measuring pulse voltage have been applied and after the corresponding read-out periods, e.g. at the time t6".

Further, fig. 8 shows an embodiment where an offset check is performed after every measuring voltage and read-out period, e.g. at the time t4"', at the time t7"' etc. It will be understood that hereby the possibility of errors caused by a change in the DC voltage level in the network will be minimized in comparison with the other examples shown in figs. 5 to 7. However, it will also be understood that if such changes are expected to be rare and/or small, it may not be found necessary to perform an offset check with the periodicity shown in fig. 8.

As exemplified that method and the system according to the invention may be applied freely and with a multitude of variations whereby the invention allows an unseen degree of flexibility in comparison with prior art systems, thus also allowing the method and the apparatus to accommodate a variety of specific applications.

Thus, it will also be understood that the measuring voltage pulses may vary in amplitude even though they have been illustrated as being of essentially similar amplitudes in figs. 5 to 8. Thus, the amplitudes may differ in dependence on the polarity and the amplitudes may be changed over time, e.g. in dependence on the characteristics of the network, the application(s), user requirements etc.

Also, it will be understood that the control means, e.g. the microprocessor may be operated in numerous different manners and be designed to perform in dependence on particular needs, requirements, applications etc.

In the above, the invention has been explained in detail with reference to specific embodiments and as illustrated in the drawings. As it will obvious to the skilled person, the invention may be performed in many other forms and variations and should not be limited to the examples of the invention illustrated above. The scope of the invention will be defined by the claims.

## Claims

1. Method of insulation monitoring of an ungrounded electric network, for example a DC and/or an AC network, wherein an insulation impedance comprising an unavoidable ohmic and capacitive insulation resistance between network and ground exists, whereby a measuring voltage in the form of a pulsed voltage is applied to the network to be monitored between network and ground, **characterized in that**
- initially an offset DC voltage is applied and adjusted until a possible DC voltage inherent in the network to be monitored is essentially compensated for, that
- a voltage pulse of said measuring voltage is applied to the network between network and ground, that
- a resulting current or a variable derived therefrom is monitored until a predetermined stage is reached, and that
- the resulting current or a variable derived therefrom determined at said predetermined stage is used for establishing an evaluation of the insulation impedance of the network.

2. Method according to claim 1, **characterized in that** said voltage pulse of said measuring voltage that may be positive or negative is terminated when said predetermined stage is reached.

3. Method according to claim 1 or 2, **characterized in that** said voltage pulse of said measuring voltage may be followed by a subsequent voltage pulse having a different or the same polarity,
- whereby a resulting current or a variable derived therefrom caused by said subsequent voltage pulse is monitored until a predetermined stage is reached, and
- that the resulting current or a variable derived therefrom determined at said predetermined stage is used for establishing a subsequent evaluation of the insulation impedance of the network.

4. Method according to one or more of claims 1 to 3, **characterized in that** a result of said evaluation or evaluations of the insulation impedance of the network is displayed, e.g. immediately following an evaluation and/or at least during a read-out period following a corresponding voltage pulse of said measuring voltage.

5. Method according to one or more of claims 1 to 4, **characterized in that** said method involves the application of at least two measuring voltage pulses having different polarities and whereby an evaluated insulation impedance is provided for e.g. read-out and/or display corresponding to a positive and a negative measuring voltage pulse, respectively.

6. Method according to one or more of claims 1 to 5, **characterized in that** said predetermined stage is reached when a predefined value of said resulting current or a variable derived therefrom is reached.

7. Method according to one or more of claims 1 to 6, **characterized in that** said predetermined stage is reached when an essentially stationary value of said resulting current or a variable derived therefrom is reached.

8. Method according to one or more of claims 1 to 7, **characterized in that** said adjustment of the DC offset voltage is performed while monitoring a currant or a derivable therefrom in said network and that a possible DC voltage inherent in the network to be monitored is considered compensated for when said DC offset voltage provides an effect essentially corresponding to said current or a derivable therefrom, for example when the difference between these is within a predefined interval, e.g. essentially zero.

9. Method according to one or more of claims 1 to 8, **characterized in that** subsequent to a termination of a voltage pulse of said measuring voltage it is controlled whether said possible DC voltage inherent in the network to be monitored is compensated for by said offset DC voltage, and if necessary an adjustment is performed.

10. Method according to one or more of claims 1 to 9, **characterized in that** said evaluation of the insulation impedance of the network provides a determination of the ohmic insulation resistance of the network.

11. Method according to one or more of claims 1 to 10, **characterized in that** said evaluation of the insulation impedance of the network provides a determination of the capacitive insulation resistance of the network.

12. Method according to one or more of claims 1 to 11, **characterized in that** said ungrounded electric network to be monitored comprises loads such as rectifiers and/or other converters.

13. Method according to one or more of claims 1 to 12, **characterized in that** said ungrounded electric network to be monitored comprises one or more phases, e.g. a three-phase-network.

14. Method according to one or more, of claims 1 to 13, **characterized in that** said method involves the step of activating an alarm, e.g. an audible and/or a visible alarm in case the insulation impedance is below a predefined threshold.

15. Method according to one or more of claims 1 to 14, **characterized in that** said method involves the step of performing an evaluation on the basis of at least two determined insulation impedance values in order to detect and possibly indicate particular fault situations, e.g. faults relating to positive or negative branches in e.g. a converter or rectifier circuit.

16. Device for insulation monitoring of an ungrounded electric network, for example a DC and/or an AC network, wherein an insulation impedance comprising an unavoidable ohmic and capacitive insulation resistance between network and ground exists, said device comprising means for applying a measuring voltage in the form of a pulsed voltage to the network to be monitored between network and ground and means for monitoring a resulting current or a variable derived therefrom, **characterized in that** said device comprises means for applying an adjustable offset DC voltage, wherein said device further comprises means for monitoring an effect of said offset DC voltage and means for automatically adjusting the adjustable offset DC voltage until a possible DC voltage inherent in the network is compensated for.

17. Device according to claim 16, **characterized in that** said device comprises control means for performing said automatic adjustment of the adjustable offset DC voltage at specific stages, e.g. subsequent to a measuring voltage pulse and with predestined intervals, e.g. after a number of measuring voltage pulses have been applied.

18. Device according to claim 16 or 17, **characterized in that** said device comprises means for determining when said resulting current or a variable derived therefrom has reached a predetermined stage, e.g. a predefined value and/or an essentially stationary value of said resulting current or a variable derived therefrom, and means for terminating said measuring pulse voltage in consequence hereof.

19. Device according to one or more of claims 16 to 18, **characterized in that** said device comprises means for applying positive and/or negative measuring pulses to said network.

20. Device according to one or more of claims 16 to 19, **characterized in that** said device comprises means for establishing an evaluation of the insulation impedance of the network on the basis of said monitored resulting current or a variable derived therefrom stemming from one or more measuring voltage pulses.

21. Device according to one or more of claims 16 to 20, **characterized in that** said device comprises display means for indicating values of said insulation impedance, e.g. the ohmic and/or capacitive insulation resistance.

22. Device according to claim 21, **characterized in that** said device comprises display means for indicating values relating to different measuring voltage pulses, e.g. negative and positive voltage pulses.

23. Device according to one or more of claims 16 to 22, **characterized in that** said device comprises means such as visible and/or audible alarm means for indicating particular fault situations, e.g. when the insulation impedance is below a predefined threshold and/or faults relating to e.g. positive or negative branches in e.g. a converter or rectifier circuit..

24. Device according to one or more of claims 16 to 23, **characterized in that** said device is designed to operate according to a method as **characterized in** one or more of claims 1 to 15.

25. Use of a device according to one or more of claims 16 to 24 in ungrounded electric networks, for example DC and/or an AC networks, said networks comprising various load, including for example rectifiers and/or other converters.

26. Use of a device according to one or more of claims 16 to 24 in ungrounded electric networks, for example DC and/or an AC networks, said networks comprising one or more phase lines, e.g. one-phase systems, three-phase systems etc.

27. Use of a device according to one or more of claims 16 to 24 in ungrounded electric networks in ships, transport means such as trains, rail vehicles etc, buildings, hospitals, industrial installations, mining installations, building sites etc.

## Patentansprüche

1. Verfahren zur Isolationsüberwachung eines nichtgeerdeten elektrischen Netzwerks, z.B. eines Gleichstrom- und/oder eines Wechselstrom-Netzwerks, in welchem eine Isolationsimpedanz existiert, die einen unvermeidbaren ohm'schen und kapazitiven Isolationswiderstand zwischen Netzwerk und Erde umfasst, wobei eine Messspannung in Form einer gepulsten Spannung an das zu überwachende Netzwerk zwischen Netzwerk und Erde angelegt wird, **dadurch gekennzeichnet, dass**
- anfänglich eine Offset-Gleichspannung angelegt und eingestellt wird, bis eine in dem zu überwachenden Netzwerk inhärente mögliche Gleichspannung im Wesentlichen kompensiert ist,
- ein Spannungspuls der Messspannung an das Netzwerk zwischen Netzwerk und Erde angelegt wird,
- ein resultierender Strom oder eine davon abgeleitete Variable überwacht wird bis eine vorgegebene Stufe erreicht ist, und
- der resultierende Strom oder eine davon abgeleitete Variable, an der besagten vorgegebenen Stufe bestimmt, verwendet wird, um eine Abschätzung der Isolationsimpedanz des Netzwerks bereitzustellen.

2. Verfahren nach Anspruch 1, **dadurch gekennzeichnet, dass** der Spannungspuls der Messspannung, die positiv oder negativ sein kann, bestimmt wird, wenn die vorgegebene Stufe erreicht ist.

3. Verfahren nach Anspruch 1 oder 2, **dadurch gekennzeichnet, dass** der Spannungspuls der Messspannung gefolgt sein kann von einem nachfolgenden Spannungspuls, der eine verschiedene oder die gleiche Polarität hat,
- wobei ein resultierender Strom oder eine davon abgeleitete Variable, durch den besagten nachfolgenden Spannungspuls bewirkt, überwacht wird, bis eine vorgegebene Stufe erreicht ist, und
- der resultierende Strom oder eine davon abgeleitete Variable, an der besagten vorgegebenen Stufe bestimmt, verwendet wird, um eine nachfolgende Abschätzung der Isolationsimpedanz des Netzwerks bereitzustellen.

4. Verfahren nach einem oder mehreren der Ansprüche 1 bis 3, **dadurch gekennzeichnet, dass** ein Ergebnis der Abschätzung oder Abschätzungen der Isolationsimpedanz des Netzwerks angezeigt wird, z.B. unmittelbar auf eine Abschätzung folgend und/oder zumindest während einer auf einen entsprechenden Spannungspuls der Messspannung folgenden Ausleseperiode.

5. Verfahren nach einem oder mehreren der Ansprüche 1 bis 4, **dadurch gekennzeichnet, dass** das Verfahren das Anlegen von mindestens zwei Messspannungspulsen beinhaltet, die verschiedene Polaritäten haben und wodurch ein Schätzwert der Isolationsimpedanz bereitgestellt wird für z.B. Auslesen und/oder Anzeige entsprechend einem positiven bzw. einem negativen Messspannungspuls.

6. Verfahren nach einem oder mehreren der Ansprüche 1 bis 5, **dadurch gekennzeichnet, dass** die besagte vorgegebene Stufe erreicht ist, wenn ein vordefinierter Wert des resultierenden Stroms oder einer davon abgeleiteten Variablen erreicht wird.

7. Verfahren nach einem oder mehreren der Ansprüche 1 bis 6, **dadurch gekennzeichnet, dass** die besagte vorgegebene Stufe erreicht ist, wenn ein im Wesentlichen stationärer Wert des resultierenden Stroms oder einer davon abgeleiteten Variablen erreicht wird.

8. Verfahren nach einem oder mehreren der Ansprüche 1 bis 7, **dadurch gekennzeichnet, dass** das Einstellen der Offset-Gleichspannung während des Überwachens eines Stroms oder einer abgeleiteten Größe davon in dem Netzwerk durchgeführt wird, und dass eine in dem zu überwachenden Netzwerk inhärente mögliche Gleichspannung als kompensiert betrachtet wird, wenn die Offset-Gleichspannung einen im Wesentlichen dem besagten Strom oder einer abgeleiteten Größe davon entsprechenden Effekt liefert, zum Beispiel, wenn die Differenz zwischen diesen innerhalb eines vordefinierten Intervalls, z.B. im Wesentlichen null ist.

9. Verfahren nach einem oder mehreren der Ansprüche 1 bis 8, **dadurch gekennzeichnet, dass** nachfolgend auf eine Bestimmung eines Spannungspulses der Messspannung kontrolliert wird, ob die in dem zu überwachenden Netzwerk inhärente mögliche Gleichspannung durch die Offset-Gleichspannung kompensiert ist, und wenn nötig eine Einstellung durchgeführt wird.

10. Verfahren nach einem oder mehreren der Ansprüche 1 bis 9, **dadurch gekennzeichnet, dass** die Abschätzung der Isolationsimpedanz des Netzwerks eine Bestimmung des ohm'schen Isolationswiderstands des Netzwerks liefert.

11. Verfahren nach einem oder mehreren der Ansprüche 1 bis 10, **dadurch gekennzeichnet, dass** die Abschätzung der Isolationsimpedanz des Netzwerks eine Bestimmung des kapazitiven Isolationswiderstands des Netzwerks liefert.

12. Verfahren nach einem oder mehreren der Ansprüche 1 bis 11, **dadurch gekennzeichnet, dass** das zu überwachende nichtgeerdete elektrische Netzwerk Lasten umfasst, so wie Gleichrichter und/oder andere Wandler.

13. Verfahren nach einem oder mehreren der Ansprüche 1 bis 12, **dadurch gekennzeichnet, dass** das zu überwachende nichtgeerdete elektrische Netzwerk eine oder mehrere Phasen umfasst, z.B. ein Drei-Phasen-Netzwerk.

14. Verfahren nach einem oder mehreren der Ansprüche 1 bis 13, **dadurch gekennzeichnet, dass** das Verfahren den Schritt eines Aktivierens eines Alarms, z.B. eines hörbaren und/oder eines sichtbaren Alarms, in dem Falle beinhaltet, dass die Isolationsimpedanz unter einem vorgegebenen Schwellwert ist.

15. Verfahren nach einem oder mehreren der Ansprüche 1 bis 14, **dadurch gekennzeichnet, dass** das Verfahren den Schritt eines Durchführens einer Abschätzung auf der Basis von mindestens zwei festgestellten Isolationsimpedanzwerten beinhaltet, um besondere Fehlersituationen zu erfassen und möglicherweise anzuzeigen, z.B. sich auf positive oder negative Zweige in z.B. einer Wandler- oder Gleichrichterschaltung beziehende Fehler.

16. Einrichtung zur Isolationsüberwachung eines nichtgeerdeten elektrischen Netzwerks, zum Beispiel eines Gleichspannungs- und/oder eines Wechselspannungsnetzwerks, in welchem eine Isolationsimpedanz existiert, die einen unvermeidbaren ohm'schen und kapazitiven Isolationswiderstand zwischen Netzwerk und Erde umfasst, wobei die Einrichtung Mittel zum Anlegen einer Messspannung in Form einer gepulsten Spannung an das zu überwachende Netzwerk zwischen Netzwerk und Erde umfasst, sowie Mittel zum Überwachen eines resultierenden Stroms oder einer davon abgeleiteten Variablen, **dadurch gekennzeichnet, dass** die Einrichtung Mittel zum Anlegen einer einstellbaren Offset-Gleichspannung umfasst, wobei die Einrichtung weiterhin Mittel zum Überwachen eines Effekts der Offset-Gleichspannung umfasst, sowie Mittel zum automatischen Einstellen der einstellbaren Offset-Gleichspannung bis eine in dem Netzwerk inhärente mögliche Gleichspannung kompensiert ist.

17. Einrichtung nach Anspruch 16, **dadurch gekennzeichnet, dass** die Einrichtung Steuermittel zum Durchführen der automatischen Einstellung der einstellbaren Offset-Gleichspannung auf spezifischen Stufen, z.B. nachfolgend auf einen Messspannungspuls und mit vorbestimmten Intervallen, z.B. nachdem eine Anzahl von Messspannungspulsen angelegt worden sind, umfasst.

18. Einrichtung nach Anspruch 16 oder 17, **dadurch gekennzeichnet, dass** die Einrichtung Mittel umfasst, um zu bestimmen, wenn der resultierende Strom oder eine davon abgeleitete Variable eine vorgegebene Stufe erreicht hat, z.B. einen vordefinierten Wert und/oder einen im Wesentlichen stationären Wert des resultierenden Stroms oder einer davon abgeleiteten Variablen, sowie Mittel zum Bestimmen der Messpulsspannung in der Folge hiervon.

19. Einrichtung nach einem oder mehreren der Ansprüche 16 bis 18, **dadurch gekennzeichnet, dass** die Einrichtung Mittel zum Anlegen von positiven und/oder negativen Messpulsen an das Netzwerk umfasst.

20. Einrichtung nach einem oder mehreren der Ansprüche 16 bis 19, **dadurch gekennzeichnet, dass** die Einrichtung Mittel umfasst, um eine Abschätzung der Isolationsimpedanz des Netzwerks auf der Basis des überwachten resultierenden Stroms oder einer davon abgeleiteten Variablen, von einem oder mehreren Messspannungspulsen stammend, bereitzustellen.

21. Einrichtung nach einem oder mehreren der Ansprüche 16 bis 20, **dadurch gekennzeichnet, dass** die Einrichtung Anzeigemittel umfasst, um Werte der Isolationsimpedanz, z.B. des ohm'schen und/oder kapazitiven Isolationswiderstands, anzugeben.

22. Einrichtung nach Anspruch 21, **dadurch gekennzeichnet, dass** die Einrichtung Anzeigemittel umfasst, um sich auf verschiedene Messspannungspulse, z.B. negative und positive Spannungspulse, beziehende Werte anzugeben.

23. Einrichtung nach einem oder mehreren der Ansprüche 16 bis 22, **dadurch gekennzeichnet, dass** die Einrichtung Mittel, so wie für einen sichtbaren und/oder hörbaren Alarm vorgesehenen Mittel umfasst, um besondere Fehlersituationen anzuzeigen, z.B. wenn die Isolationsimpedanz unterhalb eines vordefinierten Schwellwerts ist, und/oder sich auf z.B. positive oder negative Zweige in z.B. einer Wandler- oder Gleichrichterschaltung beziehende Fehler.

24. Einrichtung nach einem der mehreren der Ansprüche 16 bis 23, **dadurch gekennzeichnet, dass** die Einrichtung dazu vorgesehen ist, gemäß einem Verfahren nach einem oder mehreren der Ansprüche 1 bis 15 zu arbeiten.

25. Verwendung einer Einrichtung nach einem oder mehreren der Ansprüche 16 bis 24 in nichtgeerdeten elektrischen Netzwerken, zum Beispiel Gleichspannungs- und/oder Wechselspannungsnetzwerken, wobei die Netzwerke unterschiedliche Lasten umfassen, einschließlich zum Beispiel Gleichrichtern und/oder anderen Wandlern.

26. Verwendung einer Einrichtung nach einem oder mehreren der Ansprüche 16 bis 24 in nichtgeerdeten elektrischen Netzwerken, zum Beispiel Gleichspannungs- und/oder Wechselspannungsnetzwerken, wobei die Netzwerke eine oder mehrere Phasenleitungen umfassen, z.B. Ein-Phasen-Systeme, Drei-Phasen-Systeme, etc.

27. Verwendung einer Einrichtung nach einem oder mehreren der Ansprüche 16 bis 24 in nichtgeerdeten elektrischen Netzwerken in Schiffen, Transportmitteln, so wie Zügen, Schienenfahrzeugen, etc., Gebäuden, Krankenhäusern, Industrieanlagen, Bergwerksanlagen, Baustellen, etc.

## Revendications

1. Procédé de surveillance d'isolement d'un réseau électrique à neutre non mis à la terre, par exemple un réseau continu et/ou alternatif, dans lequel une impédance d'isolement comprenant une résistance d'isolement ohmique et capacitive inévitable entre le réseau et la terre existe, moyennant quoi une tension de mesure sous la forme d'une tension pulsée est appliquée au réseau à surveiller entre le réseau et la terre, **caractérisé en ce que**
- initialement, une tension continue de décalage est appliquée et ajustée jusqu'à ce qu'une tension continue possible inhérente dans le réseau à surveiller soit essentiellement compensée,
- une impulsion de tension de ladite tension de mesure est appliquée au réseau entre le réseau et la terre,
- un courant résultant ou une variable déduite de celui-ci est surveillé jusqu'à ce qu'un niveau prédéterminé soit atteint, et
- le courant résultant ou une variable déduite de celui-ci déterminé audit niveau prédéterminé est utilisé pour établir une évaluation de l'impédance d'isolement du réseau.

2. Procédé selon la revendication 1, **caractérisé en ce que** ladite impulsion de tension de ladite tension de mesure qui peut être positive ou négative est interrompue lorsque ledit niveau prédéterminé est atteint.

3. Procédé selon la revendication 1 ou 2, **caractérisé en ce que** ladite impulsion de tension de ladite tension de mesure peut être suivie d'une impulsion de tension suivante ayant une polarité différente ou identique,
- moyennant quoi un courant résultant ou une variable déduite de celui-ci provoqué par ladite impulsion de tension suivante est surveillé jusqu'à ce qu'un niveau prédéterminé soit atteint, et
- le courant résultant ou une variable déduite de celui-ci déterminé audit niveau prédéterminé est utilisé pour établir une évaluation ultérieure de l'impédance d'isolement du réseau.

4. Procédé selon une ou plusieurs des revendications 1 à 3, **caractérisé en ce qu'**un résultat de ladite évaluation ou desdites évaluations de l'impédance d'isolement du réseau est affiché, par exemple immédiatement à la suite d'une évaluation et/ou au moins pendant une période de lecture suivant une impulsion de tension correspondante de ladite tension de mesure.

5. Procédé selon une ou plusieurs des revendications 1 à 4, **caractérisé en ce que** ledit procédé implique l'application d'au moins deux impulsions de tension de mesure ayant différentes polarités et par lequel une impédance d'isolement évaluée est fournie, par exemple pour une lecture et/ou un affichage correspondant à une impulsion de tension de mesure positive et négative, respectivement.

6. Procédé selon une ou plusieurs des revendications 1 à 5, **caractérisé en ce que** ledit niveau prédéterminé est atteint lorsqu'une valeur prédéfinie dudit courant résultant ou d'une variable déduite de celui-ci est atteinte.

7. Procédé selon une ou plusieurs des revendications 1 à 6, **caractérisé en ce que** ledit niveau prédéterminé est atteint lorsqu'une valeur essentiellement fixe dudit courant résultant ou d'une variable déduite de celui-ci est atteinte.

8. Procédé selon une ou plusieurs des revendications 1 à 7, **caractérisé en ce que** ledit ajustement de la tension de décalage continue est effectué tout en surveillant un courant ou une variable déduite de celui-ci dans ledit réseau et **en ce qu'**une tension continue possible inhérente dans le réseau à surveiller est considérée comme étant compensée lorsque ladite tension de décalage continue fournit un effet correspondant essentiellement audit courant ou à une variable déduite de celui-ci, par exemple lorsque la différence entre celles-ci est dans les limites d'un intervalle prédéfni, par exemple essentiellement nul.

9. Procédé selon une ou plusieurs des revendications 1 à 8, **caractérisé en ce que**, à la suite d'une interruption d'une impulsion de tension de ladite tension de mesure, il est contrôlé si ladite tension continue possible inhérente dans le réseau à surveiller est compensée par ladite tension continue de décalage, et si nécessaire, un ajustement est effectué.

10. Procédé selon une ou plusieurs des revendications 1 à 9, **caractérisé en ce que** ladite évaluation de l'impédance d'isolement du réseau fournit une détermination de la résistance d'isolement ohmique du réseau.

11. Procédé selon une ou plusieurs des revendications 1 à 10, **caractérisé en ce que** ladite évaluation de l'impédance d'isolement du réseau fournit une détermination de la résistance d'isolement capacitive du réseau.

12. Procédé selon une ou plusieurs des revendications 1 à 11, **caractérisé en ce que** ledit réseau électrique non mis à la terre à surveiller comprend des charges telles que des redresseurs et/ou d'autres convertisseurs.

13. Procédé selon une ou plusieurs des revendications 1 à 12, **caractérisé en ce que** ledit réseau électrique non mis à la terre à surveiller comprend une ou plusieurs phases, par exemple un réseau triphasé.

14. Procédé selon une ou plusieurs des revendications 1 à 13, **caractérisé en ce que** ledit procédé implique l'étape d'activation d'une alarme, par exemple une alarme audible et/ou visible dans le cas où l'impédance d'isolement est inférieure à un seuil prédéfini.

15. Procédé selon une ou plusieurs des revendications 1 à 14, **caractérisé en ce que** ledit procédé implique l'étape d'exécution d'une évaluation sur la base d'au moins deux valeurs d'impédance d'isolement déterminées afin de détecter et éventuellement d'indiquer des situations de défaut particulières, par exemple des défauts concernant des branches positive ou négative, par exemple dans un circuit de conversion ou de redressement.

16. Dispositif pour la surveillance de l'isolement d'un réseau électrique non mis à la terre, par exemple un réseau continu et/ou alternatif, dans lequel une impédance d'isolement comprenant une résistance d'isolement ohmique et capacitive inévitable entre le réseau et la terre existe, ledit dispositif comprenant des moyens pour appliquer une tension de mesure sous la forme d'une tension pulsée au réseau à surveiller entre le réseau et la terre et des moyens pour surveiller un courant résultant ou une variable déduite de celui-ci, **caractérisé en ce que** ledit dispositif comprend des moyens pour appliquer une tension continue de décalage ajustable, dans lequel ledit dispositif comprend en outre des moyens pour surveiller un effet de ladite tension continue de décalage et des moyens pour ajuster automatiquement la tension continue de décalage ajustable jusqu'à ce qu'une tension continue possible inhérente dans le réseau soit compensée.

17. Dispositif selon la revendication 16, **caractérisé en ce que** ledit dispositif comprend des moyens de commande pour effectuer ledit ajustement automatique de la tension continue de décalage ajustable à des niveaux spécifiques, par exemple à la suite d'une impulsion de tension de mesure et à des intervalles prédéterminés, par exemple après l'application d'un certain nombre d'impulsions de tension de mesure.

18. Dispositif selon la revendication 16 ou 17, **caractérisé en ce que** ledit dispositif comprend des moyens pour déterminer quand ledit courant résultant ou une variable déduite de celui-ci a atteint un niveau prédéterminé, par exemple une valeur prédéfinie et/ou une valeur essentiellement fixe dudit courant résultant ou d'une variable déduite de celui-ci, et des moyens pour interrompre ladite tension d'impulsion de mesure en conséquence de cela.

19. Dispositif selon une ou plusieurs des revendications 16 à 18, **caractérisé en ce que** ledit dispositif comprend des moyens pour appliquer des impulsions de mesure positives et/ou négatives audit réseau.

20. Dispositif selon une ou plusieurs des revendications 16 à 19, **caractérisé en ce que** ledit dispositif comprend des moyens pour établir une évaluation de l'impédance d'isolement du réseau sur la base dudit courant résultant surveillé ou d'une:variable déduite de celui-ci provenant d'une ou de plusieurs impulsions de tension de mesure.

21. Dispositif selon une ou plusieurs des revendications 16 à 20, **caractérisé en ce que** ledit dispositif comprend des moyens d'affichage pour indiquer des valeurs de ladite impédance d'isolement, par exemple la résistance d'isolement ohmique et/ou capacitive.

22. Dispositif selon la revendication 21, **caractérisé en ce que** ledit dispositif comprend des moyens d'affichage pour indiquer des valeurs concernant différentes impulsions de tension de mesure, par exemple des impulsions de tension négatives et positives.

23. Dispositif selon une ou plusieurs des revendications 16 à 22, **caractérisé en ce que** ledit dispositif comprend des moyens tels que des moyens formant alarme visible et/ou audible pour indiquer des situations de défaut particulières, par exemple lorsque l'impédance d'isolement est inférieure à un seuil prédéfini et/ou des défauts concernant, par exemple, des branches positive ou négative, par exemple, dans un circuit de conversion ou de redressement.

24. Dispositif selon une ou plusieurs des revendications 16 à 23, **caractérisé en ce que** ledit dispositif est conçu pour fonctionner selon un procédé tel que **caractérisé** dans une ou plusieurs des revendications 1 à 15.

25. Utilisation d'un dispositif selon une ou plusieurs des revendications 16 à 24 dans des réseaux électriques à neutre non mis à la terre, par exemple des réseaux continus et/ou alternatifs, lesdits réseaux comprenant diverses charges, comprenant par exemple des redresseurs et/ou d'autres convertisseurs.

26. Utilisation d'un dispositif selon une ou plusieurs des revendications 16 à 24 dans des réseaux électriques à neutre non mis à la terre, par exemple des réseaux continus et/ou alternatifs, lesdits réseaux comprenant une ou plusieurs lignes de phase, par exemple des systèmes monophasés, des systèmes triphasés, etc.

27. Utilisation d'un dispositif selon une ou plusieurs des revendications 16 à 24 dans des réseaux électriques à neutre non mis à la terre dans des bateaux, des moyens de transport tels que des trains, des véhicules sur rails, etc., des bâtiments, des hôpitaux, des installations industrielles, des installations minières, des sites de construction, etc.
